# EUROPEAN PATENT SPECIFICATION

(11) **EP 0 334 906 B1**
(45) Date of publication and mention of the grant of the patent: **15.09.1993**
(21) Application number: 88906248.5
(22) Date of filing: 13.04.1988
(51) Int. Cl.: G03F 7/26

(54) **SILICON-CONTAINING NEGATIVE RESIST MATERIAL, AND PROCESS FOR ITS USE IN PATTERNING SUBSTRATES**
SILIKON ENTHALTENES NEGATIVES PHOTORESISTMATERIAL UND DESSEN VERWENDUNG ZUM HERSTELLEN VON GEMUSTERTEN OBERFLÄCHEN
MATERIAU DE RESERVE NEGATIF CONTENANT DU SILICIUM, ET SON PROCEDE D'UTILISATION DANS DES SUBSTRATS A MOTIFS

(30) Priority: 21.05.1987 US 53217
(43) Date of publication of application: 04.10.1989
(73) Proprietor: Hughes Aircraft Company, Los Angeles, California 90045-0066 (US)
(72) Inventor: GRANGER, Diana, D., Thousand Oaks, CA 91360 (US); MILLER, Leroy, J., Canoga Park, CA 91304 (US)
(74) Representative: KUHNEN, WACKER & PARTNER
(86) International application number: US8801162
(87) International publication number: WO8809527

(56) References cited:
- EP-A- 0 067 066
- EP-A- 0 236 914
- US-A- 3 272 670
- US-A- 4 481 049
- US-A- 4 551 417

## Description

This invention relates to the patterning of substrates, and, in a preferred use, to a polymer resist material and its use in conjunction with resist systems used to prepare microelectronic devices.

Microelectronic devices are miniature electronic circuits that permit hundreds or even thousands of circuit components, such as conductors, connectors, transistors, and the like to be placed onto a single small wafer that is typically less than one inch in diameter. The development of microelectronic devices has permitted computers, signal processors, and other types of electronic devices to be made to operate exceedingly fast, to have low power requirements, and to be made so small that, for example, computers which a few years ago would have filled a room now fit onto a desktop. Microelectronic devices are also used in an increasing number of other electronic products, so that the capabilities available through electronics can now be applied to many other everyday uses.

Generally, a microelectronic device is fabricated by laying out the design of the required circuit components in a flat, layered arrangement. Sometimes a number of strata of devices will be designed to lie over each other, with interconnections between the strata. The microelectronic device is then fabricated to meet this design, using a sequential manufacturing process wherein the strata are gradually built up by repeated steps of depositing materials, removing patterned arrangements of the materials, and depositing more patterned arrangements of the materials. This type of sequential operation may be continued for a dozen or more steps to form complex microelectronic devices.

A key step of microelectronic device fabrication is the deposition or removal of material in carefully defined patterns. The removal is similar to the process of a woodworker removing wood lying under the open spaces in a stencil to form, for example, depressed lettering. Deposition, the inverse of removal, is similar to painting or other deposition through the open spaces in a stencil to create raised lettering. In both cases, a pattern or stencil is used to define an area that is processed by the worker to achieve either depressed or raised features.

The patterning of microelectronic devices is conceptually similar to such woodworking, but requires the making of patterns involving features 1/100,000 as large as those of a typical woodworking stencil. One of the continuing objectives of microelectronics is to make devices that are ever smaller, so that the devices can be made to operate faster and so that more electronic functions may be packed into structures having reduced size, weight, and power consumption. For the present advanced microelectronic devices, features having characteristic minimum dimensions of less than one micrometer are fabricated.

The patterns that are used to form features on microelectronic devices therefore must meet demanding requirements. They must permit the preparation of very small features, must be readily handled, and in some cases must have special chemical properties. A number of types of patterns and pattern materials have been developed and are in use. In one typical application, a layer of a radiation-sensitive material is deposited onto a microelectronic device substrate, and a pattern is formed in the radiation-sensitive material or layer by exposure to light, electron beam, ion beam, or other type of radiation. The pattern is developed to remove the portion exposed to the radiation (a positive resist) or the portion that was not exposed to the radiation (a negative resist). A passageway to the substrate is thereby opened, and then either a portion of the substrate is removed or more material added through the opened area of the resist pattern.

The material that is used to make the pattern must be sensitive to the radiation, so that it can be chemically altered by the radiation to define the pattern. Some portion must be removable by the development process. The remaining portion of the resist material must be capable of withstanding attack by an external agent, in the case of the removal of a portion of the substrate through the opening in the pattern material, or must have the necessary chemical stability, in the case of the deposition onto the substrate through the opening in the pattern material.

In one particular type of patterning operation a bilevel resist is used, wherein there are two layers deposited upon the surface of the substrate. The pattern is defined in the top or imaging layer, and then transferred to the bottom layer adjacent to the surface. This approach has the particular advantage of achieving higher resolution of features in some circumstances than is possible with single layer patterns. In one application, the top or imaging layer must be highly resistant to removal by oxygen reactive ion etching, while still receptive of patterns produced in the layer. There is a continuing need for an imaging resist material that can be used to form this resist top layer, and which is highly resistant to oxygen reactive ion etching. The greater the resistance, the thinner the resist top layer can be made. A thin resist top layer is desirable, since the thinner the resist layer, the greater the resolution of features that can be achieved in the pattern ultimately formed on the substrate.

There is a particular need for such an upper resist layer which has the described features, is resistant to oxygen reactive ion etching, has high hardness and high sensitivity, and is a negative resist which undergoes a chemical change when exposed to radiation, so that a subsequent developing procedure removes the unexposed material. The present invention as claimed in claims 1 and 8, respectively, fulfills this need for a resist material, and further provides related advantages.

The present invention provides a resist material that can be used as the top layer of a bilevel patterning system. The resist material of the invention is suitable for ion beam or electron beam lithographic patterning, and is developed in conventional developers as a negative resist. The resist material is highly resistant to removal by oxygen reactive ion etching, so that the polymer bottom layer of the bilevel patterning system can be removed by this dry etching procedure through the openings in a pattern formed in the resist top layer. The resist material exhibits high hardness, and has good sensitivity. Using this resist material in a bilevel patterning system, resolution of features on the order of 0.1-0.5 micrometers can be achieved with a negative resist material.

In accordance with the invention, a polymer resist material consists essentially of a copolymer of a silicon-containing alkyl methacrylate having at least one trimethylsiloxysilyl group, and a halogenated styrene. The preferred alkyl methacrylate is 3-methacryloyloxypropyltris(trimethylsiloxy)silane, and the preferred halogenated styrene has a halogen or halogen-containing group substituted into the 3 or 4 position of the styrene ring.

The resist material is used in the patterning of substrates, with particular application in the area of patterning microelectronic substrates. In this aspect of the invention, a process for patterning a substrate with a negative resist, comprises the steps of forming a top layer of a polymer resist material overlying the substrate, the polymer resist material consisting essentially of a copolymer of a silicon-containing alkyl methacrylate having at least one trimethylsiloxysilyl group, and a halogenated styrene; irradiating a pattern on the polymer resist material top layer; and developing the patterned resist material top layer, thereby removing that portion of the polymer resist top layer that was not irradiated in the step of irradiating. As used herein, the term "overlying" indicates that an overlying layer is above another layer or structure, but does not necessarily contact the other layer or structure, as, for example, the top layer in a trilevel resist system.

More specifically, the resist materials described above can be used in a bilevel patterning system, wherein the polymer resist top layer overlies an organic polymer bottom layer, which in turn overlies the substrate. In this approach, a process for patterning a substrate comprises the steps of forming a bottom layer of an organic polymer material overlying the substrate; forming a top layer of a polymer resist material overlying the bottom layer of organic polymer material, the polymer resist material consisting essentially of a copolymer of a silicon-containing alkyl methacrylate having at least one trimethylsiloxysilyl group, and a halogenated styrene; irradiating a pattern on the polymer resist material; developing the patterned resist material top layer, thereby removing that portion of the polymer resist top layer that was not irradiated in the step of irradiating; and removing the portion of the polymer bottom layer which lies under the portion of the top layer removed in the step of developing.

It is believed that the trimethylsiloxysilyl group of the methacrylate polymer is important in providing the improved properties of the present resist material. At least one trimethylsiloxysilyl group is provided, and preferably up to two additional trimethylsiloxy groups, each attached to the silane, are present. In some embodiments, having three trimethylsiloxy groups, the methacrylate monomer contains as much as 28 percent by weight silicon, and the final resist copolymer contains as much as 18-20 percent or more by weight silicon. The high silicon content of the final copolymer in the resist imparts excellent resistance to removal by and damage in oxygen reactive ion etching. The resist material top layer can therefore be made quite thin, with the result that high resolution can be obtained on the substrate when the patterned and developed resist material layer is used as a mask.

A wide variety of styrenes halogenated with one or more chlorine, bromine, or iodine atoms have been established as operable. The mole ratio of the halogenated styrene to the alkyl methacrylate having at least one trimethylsiloxysilyl group can vary widely, in a ratio of from about 0.1 to about 9 moles of the halogenated styrene to 1 mole alkyl methacrylate. If too little of the halogenated styrene is used, the polymer is rubbery and does not hold its shape well on the substrate. Good shape retention is important, so that precise patterns can be defined. Otherwise, relaxation of the resist material results in sagging of the pattern and distortion of its previously precisely defined shape. If too much of the halogenated styrene is used, the correspondingly low level of the silicon-containing alkyl methacrylate results in insufficient resistance of the resist top layer to oxygen reactive ion etching.

The polymer resist material of the invention is used as a negative resist, preferably in a bilevel patterning system. It is readily prepared and used, without substantial changes in existing patterning procedures. It can be patterned by ion beam and electron beam lithography, and possibly by ultraviolet or X-ray lithography. The resist polymer has a high silicon content, and is therefore highly resistant to removal by oxygen reactive ion etching. A thin resist layer of this material can be used, leading to high resolution images and patterns. Other features and advantages of the invention will be apparent from the following more detailed description of the preferred embodiments, taken in conjunction with the accompanying drawings, which illustrate, by way of example, the principles of the invention.
Figure 1 is a side elevational view of a bilevel patterning system on a substrate; and
Figure 2 is a diagrammatic flow chart illustrating the deposition of the patterning system and the patterning of the substrate using the bilevel patterning system of Figure 1 with a negative resist top layer.

The preparation of one preferred polymer resist and its use in a bilevel patterning system will be presented in detail. The polymer is a copolymer of 4-chlorostyrene (known in abbreviated form as 4CS) and 3-methacryloyloxypropyltris(trimethylsiloxy)silane (known in abbreviated form as MOTSS), in a ratio of about 3.5 moles of 4CS per mole of MOTSS. (MOTSS is also sometimes known as 3-methacryloxypropyltris(trimethylsiloxy)silane.)

MOTSS was obtained from Petrarch Systems, Inc., and 4CS monomer was obtained from Aldrich. To prepare the copolymer, 10.9 grams of 4CS and 9.4 grams of MOTSS were mixed with 40 milliliters of benzene and processed in a freeze-thaw degas treatment to remove gas from the mixture. Benzoyl peroxide, used as an initiator of the copolymerization process, was added to the mixture as a mixture of 216 milligrams of the benzoyl peroxide in 1.5 milliliters of benzene. The mixture was placed into a reaction flask fitted with a reflux condenser and refluxed at 80^{o}C, the boiling point of the benzene, for about 6 hours, and cooled.

An equal volume of acetone was added to the refluxed material, and the mixture was added to 2 liters of methanol. The polymer was extracted from the methanol, and dried in a vacuum at ambient temperature in an evaporation dish. The dried polymer was dissolved in a sufficient amount of methyl isobutyl ketone (MiBK) solvent (or alternatively, acetone) to make a solution having from 5 to 20 weight/volume percent polymer. The polymer was then reprecipitated in 2 liters of methanol and vacuum dried at ambient temperature overnight.

The resulting copolymer was dissolved in an appropriate spin casting solvent, such as MiBK, toluene, or chlorobenzene. The solution was filtered to 0.2 micrometers, and coated overlying the substrate, by spin casting, at the appropriate point in the processing, and in the manner, to be described subsequently.

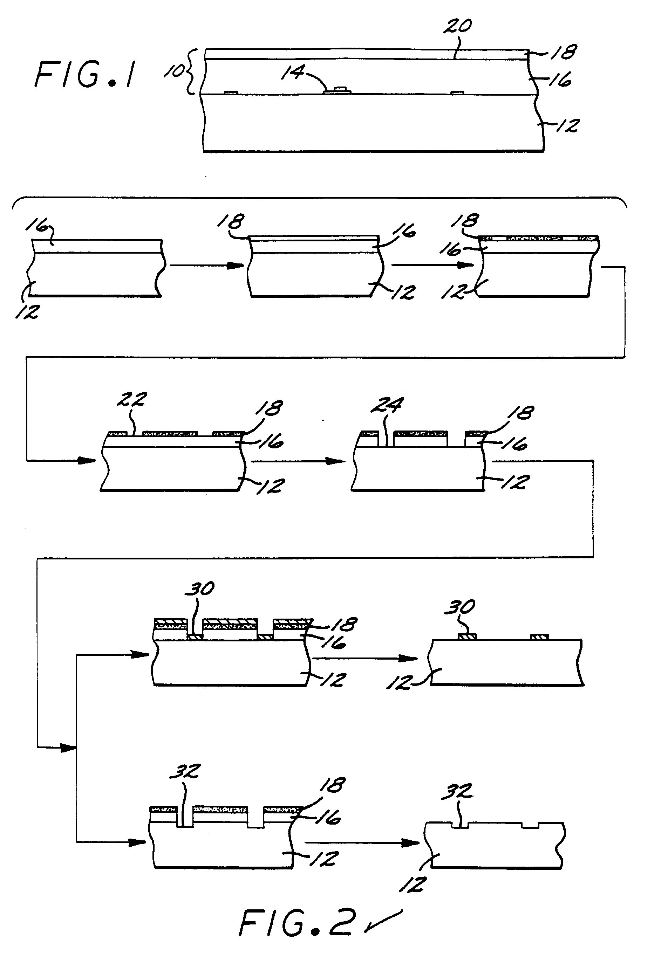

The use of this copolymer as a resist material is illustrated in Figures 1 and 2, for the preferred application in a bilevel patterning system. In Figure 1, a bilevel patterning system 10 is located on a substrate 12. The substrate 12 is typically an microelectronic chip, which may already have some circuit structure 14 fabricated thereupon during prior processing.

The bilevel patterning system 10 includes a relatively thick organic polymer bottom layer 16 deposited overlying the substrate 12. The organic polymer bottom layer 16 is prepared from any suitable material which is not dissolved or lifted off in the solvent developer or nonsolvent used in the processing, and is otherwise compatible with the subsequent processing. Hard baked AZ photoresists, containing novolacs, resist dissolution and lift off, and are preferred. The layer 16 can be any suitable solid organic polymer, such as AZ1350J, AZ1350B, or AZ1370SF, available from American Hoechst, or poly(methyl methacrylate) (PMMA). The indicated polymers happen to be resist materials, and are used because they are readily available in facilities which do microelectronic patterning work and have the necessary chemical characteristics, and because workers know how to prepare and use them. Polymers that are not resist materials are acceptable for the layer 16, as the resist properties are not used in this preferred form of the invention. The layer 16 is typically hardbaked before use, which in any event destroys any photosensitivity that it might have. The thickness of the polymer bottom layer 16 is not critical, and it typically is from about 0.5 to about 2 micrometers (or more) thick.

The polymer resist material of the invention is present as a resist top layer 18 overlying the layer 16 and the substrate 12. One such preferred resist top layer 18 is prepared from 4CS and MOTSS and applied as previously described. The resist top layer 18, as applied, is typically from about 0.15 to about 0.5 micrometers thick, and is applied to be uniformly thick over the bottom layer 16.

The procedure for the application of the layers 16 and 18, and the formation of a pattern therein is illustrated diagrammatically in Figure 2. First, the polymer layer 16 is deposited on the substrate 12 by spin casting, to the desired thickness, and dried by hard baking at a temperature of from about 150^{o}C to about 200^{o}C, so that the layers 16 and 18 do not intermix. The layer 16 is made sufficiently thick to leave a smooth, flat upper surface 20, whose upper surface smoothness is not impaired by any underlying structure 14. The polymer resist material of the invention is then applied over the bottom layer 16 to form the top layer 18 of the desired thickness, as by spin casting. The layer 18 is dried at a temperature of 60^{o}C to 80^{o}C for about 30 minutes. Drying in a vacuum accelerates removal of the solvent. The application of the patterning system 10 is now complete.

Patterning of the substrate is accomplished by writing an image into the resist material layer 18 by an electron or ion beam. (It is believed that X-ray and ultraviolet light radiation would also be operable.) Exposure may be by a focused beam or by flood exposure through a mask. The intensity and energy of the radiation are adjusted to provide a sufficient dosage to cause a chemical reaction in the exposed portion of the resist material that it later resists removal in the developer.

The image is developed by dip or spray developing with an appropriate solvent-nonsolvent sequence, in which the layer 18 is first contacted to a concentrated solvent, then to one or more solutions of progressively less concentrated solvents or to a liquid having a structure intermediate that of the solvent and the nonsolvent, and finally to a nonsolvent, such as an alcohol. In one exemplary version of this developing procedure, the resist is first immersed into, or sprayed with, the solvent 2-ethoxyethyl acetate (cellosolve acetate). (Some other useful solvents include methyl isobutyl ketone, dimethylacetamide, n-propyl acetate, butoxyethyl acetate, and chlorobenzene.) In dipped development, to ensure that the background is free of residual soluble copolymer, the development step with the strong solvent is often repeated with a fresh portion of the same solvent. The surface is then rinsed with an intermediate rinse of 2-ethoxyethanol (cellosolve) or a dilute solvent such as a 10-50% mixture of the developer solvent and a nonsolvent such as isopropyl alcohol. The surface is finally rinsed in isopropyl alcohol or other appropriate nonsolvent. The top layer 18 and the substrate are not permitted to dry between contacting to successive solutions in this procedure, reducing the likelihood of swelling and distortion of the layer 18. The developing procedure is more fully described in US Patent 4,535,054, whose disclosure is herein incorporated by reference.

The result of the developing procedure is a pattern 22 etched into the upper resist material layer 18, but which does not penetrate into the polymer layer 16. The pattern 22 remaining after developing is a negative pattern. That is, the portion of the resist layer 18 that was exposed to radiation remains after the developing, and it is the unexposed portion of the resist layer 18 that is removed. (This is to be contrasted with a positive resist, wherein the portion of the layer that was exposed to radiation is removed by the developer. Whether a material is a positive or negative resist depends upon its structure and chemistry, and the resist material of the present invention is a negative resist.)

The pattern 22 is transferred to the polymer layer 16 by any appropriate process, but preferably by a dry etching process such as oxygen reactive ion etching. In this preferred process, energized oxygen atoms are impacted into the exposed surface of the pattern. Unless it is resistant to the impacting, the bombarded area is removed. In the case of the resist material of the invention, the high silicon content renders it highly resistant to the reactive ion etching. As a result, the pattern 22 is duplicated with excellent accuracy in the organic polymer layer 16. The upper surface of the resist layer 18 is worn away very slowly, and therefore it protects the portion of the layer 16 that is not to be removed by the oxygen reactive ion etching.

The transfer of the pattern 22 to the layer 16 results in a pattern 24 opened to the surface of the substrate 12. This pattern 24 can then be further processed as necessary, either by a deposition of material into the pattern, or by etching the substrate material lying below the opening in the pattern. When the deposition or removal is complete, the entire pattern structure 10 is dissolved or lifted away in a resist stripping solvent appropriate for the polymer in the bottom layer 16. The procedure is then complete, and the processed substrate is ready for use or for further processing operations.

The alkyl methacrylate used in the invention is generally of the form: 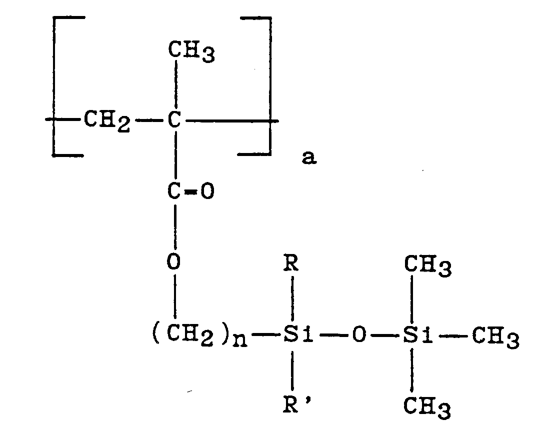
where R, R' is ―O―Si(CH₃)₃, CH₃, alkyl, or phenyl, and n is 1, 2 or 3. As used herein, the ―O―Si(CH₃)₃ group is termed a trimethylsiloxy group, while the 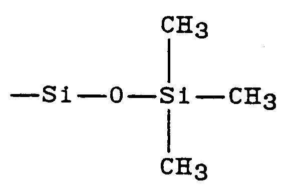
group is termed a trimethylsiloxysilyl group. Thus, it can be seen that the alkyl methacrylate must contain at least one trimethylsiloxysilyl group, and optionally contains one or two additional trimethylsiloxy groups joined to the silane. Various members of this family, in addition to the preferred alkyl methacrylate, may be used.

The halogenated styrene used in the invention is generally of the form: 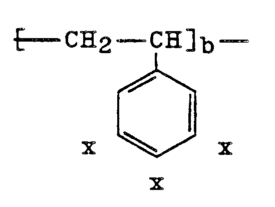
where x is Cl, Br, or I, or a group containing Cl, Br, or I. For example, the x group may be CH₂Cl, CH₂Br, or CH₂I.

In the illustrated general structure, x groups are shown in the 3, 4 and 5 positions of the ring, although in the usual nomenclature for one or two substitutions, mention is made of only the 3 (meta) and 4 (para) positions. In the structures of the invention, one to three substitutions are permitted. The actual structure can include x in any of these positions, or in some combination of these positions. Halogenated styrenes have been prepared and evaluated with Cl, Br, or I in the 4 position; CH₂Cl in the 3 and 4 positions; Cl in the 3 position, and Cl in the 3 and 4 positions. All of these halogenated styrenes have been operable, and it is believed that related structures will be operable.

The following examples are presented to illustrate various aspects of embodiments of the invention, but should not be taken as limiting the invention in any respect.

### Example 1

30.8 grams (0.0728 moles) of MOTSS was combined with 10.4 grams (0.0750 moles) of 4-chlorostyrene in 50 milliliters of benzene in a three-neck, round-bottom flask fitted with a rubber septum, a condenser, and a gas inlet tube with provisions for either evacuating or filling with nitrogen. the solution was freeze-thaw degassed three times, and a solution of 0.295 grams of benzoyl peroxide in 3 milliliters of benzene was injected through the septum with a syringe onto the frozen solution during the last cycle. The thawed solution was stirred with a magnetic stirrer, heated to boiling, and kept at reflux for 6 hours. After cooling to room temperature, the reaction mixture was combined with an equal volume of acetone and stirred, and the resulting solution was slowly added to 2 liters of stirred methanol. The precipitated product was isolated, redissolved in about 200 milliliters of acetone, and reprecipitated by adding the solution slowly to 2 liters of stirred, cold methanol at about -15^{o}C. The reprecipitated polymer was collected and dried to constant weight in a vacuum at ambient temperature. The weight of the copolymer was 26.9 grams, a 65 percent yield.

### Example 2

The procedure of Example 1 was repeated, except that the reaction mixture was composed of 31.4 grams (0.0743 moles) of MOTSS, 12.9 grams (0.0845 moles) of chloromethylstyrene, 56 milliliters of benzene, and 0.325 grams of benzoyl peroxide. The yield of copolymer was 38.1 grams, an 86 percent yield.

### Example 3

The procedure of Example 1 was repeated, except that the reaction mixture was composed of 15.7 grams (0.0371 moles) of MOTSS, 23.8 grams (0.130 moles) of 4-bromostyrene, 75 milliliters of benzene, and 0.138 grams of benzoyl peroxide. The weight of the copolymer was 11.7 grams, a 30 percent yield.

### Example 4

The procedure of Example 1 was repeated, except that the reaction mixture was composed of 18.2 grams (0.0430 moles) of MOTSS, 21.9 grams (0.158 moles) of 3-chlorostyrene, 93 milliliters of benzene, and 0.094 grams of benzoyl peroxide, and the mixture was heated for 12 hours at 75^{o}C. The weight of copolymer was 9.36 grams, a 23 percent yield.

### Example 5

The procedure of Example 1 was repeated, except that the reaction mixture was composed of 26.7 grams (0.063 moles) of MOTSS, 10.9 grams (0.0630) moles) of 3,4-dichlorostyrene, 36 milliliters of benzene, and 0.102 grams of benzoyl peroxide, and the mixture was heated for 12 hours at 70^{o}C. The weight of copolymer was 6.6 grams, an 18 percent yield.

### Examples 6-10

Five test wafers were prepared of silicon coated with a spin-coated bottom layer of AZ1370SF organic polymer approximately 1 micrometer thick. The bottom layer was hard baked at 200^{o}C for 3 hours in air. Solutions were prepared of each of the copolymers produced in Examples 1-5 by dissolving the copolymer in a spin casting solvent in the proportion of about 10 grams of copolymer for about 100 milliliters of spin casting solvent. The spin casting solvents used were methyl isobutyl ketone for the copolymers of Examples 1, 4, and 5, and xylene for the copolymers of Examples 2 and 3. Each of the resulting solutions was filtered to 0.2 micrometers and spin cast onto one of the coated silicon wafers to a thickness of about 0.3 micrometers to form a top layer thereupon. The solvent was removed from the top layer of each coated wafer by baking the coated wafer at a temperature of 60^{o}C to 80^{o}C for 30 minutes in vacuum.

A pattern was defined in the top layer of each of the wafers by exposure with an electron beam having an energy of 20keV and a flux of 10-25 amps per square centimeter, depending on the sensitivity of the top layer copolymer. The pattern was developed by immersing the exposed wafer in 2-ethoxyethyl acetate for 30 seconds, in a fresh solution of 2-ethoxyethyl acetate for 30 seconds, in 2-ethoxyethanol for 30 seconds, and finally in isopropyl alcohol for 30 seconds. The result in each case was a patterned top layer, from which had been removed those portions of the top layer that had not been exposed to the electron beam. That is, the resist material was established as a negative resist material.

The portion of the bottom layer lying under the openings through the pattern in the top layer was removed by oxygen reactive etching in an MRC RIE 51 reactive ion etcher. Oxygen gas was used, at a pressure of 18 millitorr and a flow rate of 20 Standard cubic centimeters per minute, with an applied voltage of 450-480 volts and 50 watts power. A fully satisfactory patterned wafer resulted. Material could then be deposited upon the surface of the wafer through the etched opening, or removed from the surface of the wafer, by standard techniques.

Examples 1-5 illustrate some of the copolymers that can be prepared in accordance with the invention. Examples 6-10 illustrate the use of these copolymers in preparing patterned substrates.

It will be appreciated that the resist material and process of the invention provide an important advance in the art of lithography. Negative patterns can be placed onto a substrate readily using a bilevel or multilevel resist scheme, with a resist layer of minimal thickness because of its high silicon content. Although a particular embodiment of the invention has been described in detail for purposes of illustration, various modifications may be made without departing from the spirit and scope of the invention. Accordingly, the invention is not to be limited except as by the appended claims.

## Claims

1. A polymer negative resist material, consisting essentially of a copolymer of a silicon-containing alkyl methacrylate having at least one trimethylsiloxysilyl group, and halogenated styrene.

2. The resist material of claim 1, wherein said silicon-containing alkyl methacrylate having at least one trimethylsiloxysilyl group has three trimethylsiloxy groups.

3. The resist material of claim 1, wherein said silicon-containing alkyl methacrylate having at least one trimethylsiloxy group is 3-methacryloyloxy-propyl-tris(trimethylsiloxy)silane.

4. The resist material of claim 1, wherein said halogenated styrene is selected from the group consisting of 4-chlorostyrene, 4-bromostyrene, 4-iodostyrene, 3-chloromethylstyrene, 4-chloromethylstyrene, 3-chlorostyrene, and 3,4-dichlorostyrene, and mixtures thereof.

5. The resist material of at least one of the claims 1 through 4, wherein the mole ratio of the halogenated styrene to the alkyl methacrylate is from about 0.1 to about 9 moles of halogenated styrene to 1 mole of alkyl methacrylate.

6. The resist material of at least one of the claims 1 through 5, wherein said resist material undergoes a chemical change when exposed to electron beam radiation.

7. The resist material of at least one of the claims 1 through 5, wherein said resist material undergoes a chemical change when exposed to ion beam radiation.

8. A process for patterning a substrate with a polymer negative resist material according to at least one of the claims 1 through 7, comprising the steps of:
forming a top layer of said resist material overlying the substrate;
irradiating a pattern on said resist material top layer; and
developing said patterned resist top layer, thereby removing that portion of said resist top layer that was not irradiated in said step of irradiating.

9. The process of claim 8, including, prior to said step of forming a top layer of said resist material, the additional step of:
forming a bottom layer of an organic polymer material overlying the substrate, so that the top layer of said resist material is formed overlying the bottom layer of the polymer material.

10. The process of claim 9, including, after said step of developing, the additional step of:
removing the portion of the organic polymer material which does not lie under the irradiated pattern by reactive ion etching with oxygen.

## Patentansprüche

1. Ein polymeres negatives Resistmaterial, das im wesentlichen aus einem Copolymer aus einem siliziumhaltigen Alkylmethacrylat mit wenigstens einer Trimethylsiloxysilylgruppe und halogeniertem Styrol besteht.

2. Das Resistmaterial nach Anspruch 1, wobei das siliziumhaltige Alkylmethacrylat mit wenigstens einer Trimethylsiloxysilylgruppe drei Trimethylsiloxygruppen enthält.

3. Das Resistmaterial nach Anspruch 1, wobei das siliziumhaltige Alkylmethacrylat mit wenigstens einer Trimethylsiloxygruppe 3-Methacryloyloxy-propyl-tris(trimethylsiloxy)silan ist.

4. Das Resistmaterial nach Anspruch 1, wobei das halogenierte Styrol aus der folgenden Gruppe ausgewählt ist: 4-Chlorstyrol, 4-Bromstyrol, 4-Jodstyrol, 3-Chlormethylstyrol, 4-Chlormethylstyrol, 3-Chlorstyrol, 3,4-Dichlorstyrol und Gemische hieraus.

5. Das Resistmaterial nach wenigstens einem der Ansprüche 1 - 4, wobei das Molverhältnis von dem halogeniertem Styrol zu dem Alkylmethacrylate von etwa 0,1 bis etwa 9 mol halogeniertes Styrol zu 1 mol Alkylmethacrylat beträgt.

6. Das Resistmaterial nach wenigstens einem der Ansprüche 1 - 5, wobei das Resistmaterial einer chemischen Veränderung unterliegt, wenn es Elektronenstrahlung ausgesetzt ist.

7. Das Resistmaterial nach einem der Ansprüche 1 - 5, wobei das Resistmaterial einer chemischen Veränderung unterliegt, wenn es Ionenstrahlung unterworfen wird.

8. Ein Verfahren zur Musterbildung eines Substrats mit einem polymeren negativen Resistmaterial nach wenigstens einem der Ansprüche 1 - 7, enthaltend die folgenden Schritte:
man bildet eine oberste Schicht aus dem Resistmaterial, die über dem Substrat liegt;
man bildet durch Bestrahlung ein Muster auf der obersten Schicht aus Resistmaterial; und
man entwickelt die mit Muster versehene oberste Resistschicht, wobei man den Anteil der obersten Resistschicht entfernt, der in der Bestrahlungsstufe nicht bestrahlt worden ist.

9. Das Verfahren nach Anspruch 8, das vor der Stufe der Bildung einer obersten Schicht aus dem Resistmaterial die folgende Stufe aufweist:
man bildet eine unterste Schicht aus einem organischen polymeren Material, die über dem Substrat liegt, so daß die oberste Schicht aus Resistmaterial über der untersten Schicht aus polymerem Material liegt.

10. Das Verfahren nach Anspruch 9, das nach der Entwicklungsstufe die folgende zusätzliche Stufe enthält: man entfernt den Anteil des organischen polymeren Materials, der nicht unter dem bestrahlten Muster liegt, durch reaktives Ionenätzen mit Sauerstoff.

## Revendications

1. Matière polymérique de réserve négative, consistant essentiellement en un copolymère d'un méthacrylate d'alkyle contenant du silicium, possédant au moins un groupe triméthylsiloxysilyle, et d'un styrène halogéné.

2. Matière de réserve suivant la revendication 1, dans laquelle le méthacrylate d'alkyle contenant du silicium possédant au moins un groupe triméthylsiloxysilyle possède trois groupes triméthylsiloxy.

3. Matière de réserve suivant la revendication 1, dans laquelle le méthacrylate d'alkyle contenant du silicium possédant au moins un groupe triméthylsiloxy est le 3-méthacryloyloxypropyl-tris(triméthylsiloxy)silane.

4. Matière de réserve suivant la revendication 1, dans laquelle le styrène halogéné est choisi dans le groupe consistant en 4-chlorostyrène, 4-bromostyrène, 4-iodostyrène, 3-chlorométhylstyrène, 4-chlorométhylstyrène, 3-chlorostyrène, et 3,4-dichlorostyrène et leurs mélanges.

5. Matière de réserve suivant au moins l'une des revendications 1 à 4, dans laquelle le rapport molaire du styrène halogéné au méthacrylate d'alkyle va d'environ 0,1 à environ 9 moles de styrène halogéné à une mole de méthacrylate d'alkyle.

6. Matière de réserve suivant au moins l'une des revendications 1 à 5, qui subit une modification chimique lors d'une exposition à un rayonnement consistant en un faisceau d'électrons.

7. Matière de réserve suivant au moins l'une des revendications 1 à 5, qui subit une modification chimique lors d'une exposition à un rayonnement consistant en un faisceau ionique.

8. Procédé d'impression d'un motif sur un substrat avec une matière polymérique de réserve négative suivant au moins l'une des revendications 1 à 7, comprenant les étapes :
de formation d'une couche supérieure de ladite matière de réserve recouvrant le substrat ;
d'irradiation d'un motif sur ladite couche supérieure de matière de réserve ; et
de développement de ladite couche supérieure de matière de réserve munie d'un motif, pour éliminer ainsi la portion de ladite couche supérieure de matière de réserve qui n'a pas été irradiée dans ladite étape d'irradiation.

9. Procédé suivant la revendication 8, comprenant, avant l'étape de formation d'une couche supérieure de la matière de réserve, l'étape supplémentaire :
de formation d'une couche inférieure d'une matière polymérique organique recouvrant le substrat, de telle sorte que la couche supérieure de ladite matière de réserve soit formée en recouvrant la couche inférieure de la matière polymérique.

10. Procédé suivant la revendication 9, comprenant, après l'étape de développement, l'étape supplémentaire :
d'élimination de la portion de la matière polymérique organique qui ne se trouve pas sous le motif irradié, par attaque par ions réactifs avec de l'oxygène.
